# EUROPÄISCHE PATENTSCHRIFT

(11) **EP 2 625 713 B1**
(45) Veröffentlichungstag und Bekanntmachung des Hinweises auf die Patenterteilung: **17.04.2019**
(21) Anmeldenummer: 11761075.8
(22) Anmeldetag: 23.09.2011
(51) Int. Cl.: H01L 23/495, H01L 21/56

(54) **ELEKTRONISCHE BAUGRUPPE**
ELECTRONIC MODULE
ENSEMBLE ÉLECTRONIQUE

(30) Priorität: 07.10.2010 DE 102010042168
(43) Veröffentlichungstag der Anmeldung: 14.08.2013
(73) Patentinhaber: Robert Bosch GmbH, 70442 Stuttgart (DE)
(72) Erfinder: KEIL, Matthias, 72760 Reutlingen (DE)
(86) Internationale Anmeldenummer: PCT/EP2011/066608
(87) Internationale Veröffentlichungsnummer: WO 2012/045600

(56) Entgegenhaltungen:
- WO-A2-2005/059995
- DE-A1-102007 032 142
- DE-A1-102008 040 488
- US-A- 5 332 921
- US-A1- 2004 156 173

## Beschreibung

### Stand der Technik

Die vorliegende Erfindung betrifft eine elektronische Baugruppe, insbesondere eine Leistungselektronik.

Elektronische Baugruppen werden im Stand der Technik vielfältig verwendet. Hierbei werden die elektronischen Baugruppen als Mold-Module vorgesehen. Diese Mold-Module können eine einseitig freiliegende, von der Mold-Masse nicht umschlossene Fläche aufweisen, sogenannte Exposed-Pads, über welche eine Ableitung von Wärme erfolgen kann. Üblicherweise werden diese wärmeableitenden, nach außen gerichteten Flächen durch Abfräsen oder Abschleifen der Oberflächen der Mold-Module erzeugt. Dies ist jedoch relativ aufwendig und zeitintensiv. Ferner kann es bei derartigen spanabhebenden Vorgängen zu Beschädigungen der elektronischen Baugruppe kommen.

DE 10 2008 040 488 A1 beschreibt eine elektronische Baueinheit mit einem Bauelemente tragenden Leitersubstrat, das mit einem mechanischen Schutz umgeben ist. Des Weiteren ist ein federelastischer, elektrischer Verbindungsleiter auf dem Leitersubstrat und in einer Moldmasse eingebettet vorgesehen.

US 2004/0156173 A1 zeigt eine Halbleiteranordnung, bei welcher mittig ein Wärmeverteiler vorgesehen ist, auf welchem elastische und thermisch leitfähige Elemente angeordnet sind. Auf den elektrisch leitfähigen Elementen wiederum sind zu jeder Seite des Wärmeverteilers ein elektronischer Chip vorgesehen, der auf einer den elektrisch leitfähigen Elementen gegenüber liegenden Seite des Chips angeordnet ist. An der Außenseite der Leiterplatte sind Bälle angeordnet.

US 5,332,921 zeigt eine in einer Harzmasse eingebettete Halbleiterbaugruppe, innerhalb einer gebogenen Metallblechanordnung. An zwei einander gegenüber liegenden Seiten des Metallblechs sind jeweils ein Schaltkreissubstrat angeordnet, auf welchen metallene Drahtanschlussplatten vorgesehen sind. Auf manchen der Drahtanschlussplatten sind Halbleiterelemente aufgelötet. Die aufgelöteten Halbleiterelemente sowie die metallenen Anschlussplatten sind untereinander mittels Drähten verbunden.

DE 10 2007 032 142 A1 zeigt ein Elektronikmodul und ein Verfahren zur Herstellung eines solchen Elektronikmoduls, wobei das Elektronikmodul ein elektronisches Bauelement in einem Spritzpressgehäuse aufweist. Aus dem Gehäuse ragen als Stanzgitter ausgebildete Anschlüsse hervor. Des Weiteren sind zwei Substrate in dem Gehäuse vorgesehen.

WO2005/059995 zeigt ein in einer Harzmasse eingebettetes Halbleiterelement, innerhalb einer gebogenen Leiterrahmenanordnung.

### Offenbarung der Erfindung

Die erfindungsgemäße elektronische Baugruppe wird mit den Merkmalen des Anspruchs 1 beschrieben.

Die beiden Schaltungsträger und die Federvorrichtung sind als ein integrales Bauteil vorgesehen. Hierdurch kann die Anzahl der Einzelteile reduziert werden und eine Herstellung ist besonders kostengünstig möglich.

Die beiden Schaltungsträger und die Federvorrichtung sind als Leadframe vorgesehen, wobei das Leadframe derart umgebogen ist, dass die beiden Schaltungsträger sowie die Federvorrichtung gebildet werden. Die Federvorrichtung kann beispielsweise durch mehrfaches Umbiegen des Leadframes erhalten werden, so dass ein federnder Bereich erhalten wird.

Zusätzlich zu der integrierten Federvorrichtung ist noch eine zweite, separate Federvorrichtung vorgesehen. Hierdurch ist es möglich, dass die Schaltungsträger an zwei verschiedenen Positionen, insbesondere an einander gegenüberliegenden Endbereichen, federnd abgestützt werden können.

Gemäß einer weiteren bevorzugten Ausgestaltung der Erfindung haben die beiden Schaltungsträger einen gemeinsamen elektrischen Verbindungsanschluss.

Gemäß einer bevorzugten Ausgestaltung der vorliegenden Erfindung umfasst die Federvorrichtung zusätzlich eine elektrisch leitende Funktion. Somit weist die Federvorrichtung neben der Federeigenschaft noch eine weitere Eigenschaft auf, so dass beispielsweise elektrische Verbindungen vom ersten zum zweiten Schaltungsträger über die Federvorrichtung realisiert werden können.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematische Schnittansicht einer elektronischen Baugruppe gemäß Stand der Technik,

- Figur 2: eine schematische Schnittansicht der elektronischen Baugruppe von Figur 1 während des Herstellungsprozesses,
- Figur 3: eine schematische Schnittansicht einer elektronischen Baugruppe gemäß dem Ausführungsbeispiel der Erfindung, und
- Figur 4: eine schematische Schnittansicht der elektronischen Baugruppe von Figur 3 während des Herstellungsprozesses,

### Bevorzugte Ausführungsformen der Erfindung

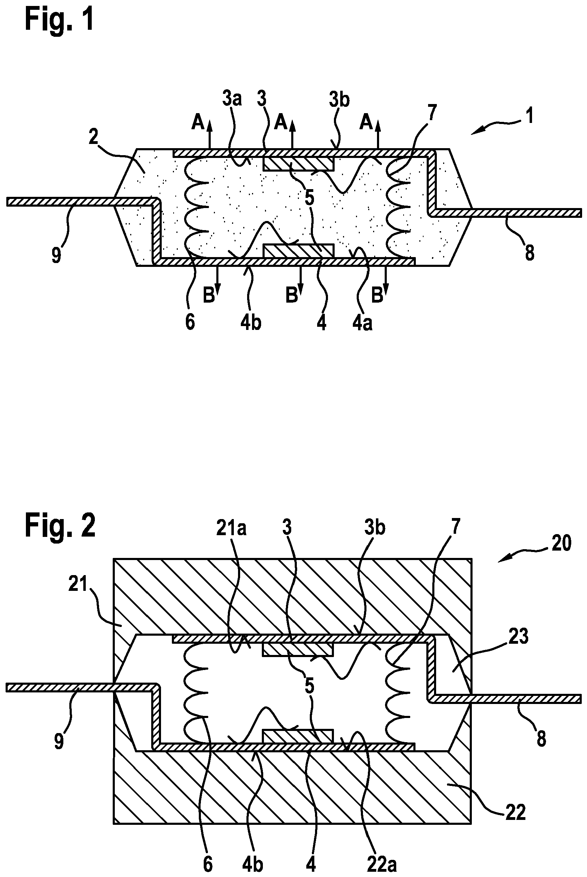

Nachfolgend wird unter Bezugnahme auf die Figuren 1 und 2 eine elektronische Baugruppe 1 gemäß Stand der Technik im Detail beschrieben.

Wie aus Figur 1 ersichtlich ist, umfasst die elektronische Baugruppe 1 einen Mold-Körper 2, einen ersten Schaltungsträger 3 und einen zweiten Schaltungsträger 4. Der erste Schaltungsträger 3 weist einen ersten elektrischen Verbindungsanschluss 8 auf und der zweite Schaltungsträger 4 weist einen zweiten elektrischen Verbindungsanschluss 9 auf. Es sei angemerkt, dass jeder der Schaltungsträger auch mehrere elektrische Verbindungsanschlüsse aufweisen kann. Die beiden Schaltungsträger 3, 4 sind als separate Bauteile vorgesehen. Beide Schaltungsträger 3, 4 sind im Wesentlichen flächenartige Bauteile mit einer Innenseitenfläche 3a und einer Außenseitenfläche 3b bzw. einer Innenseitenfläche 4a und einer Außenseitenfläche 4b. An den Innenseitenflächen 3a, 4a sind in bekannter Weise elektronische Bauteile 5 angeordnet.

Wie weiter aus Figur 1 ersichtlich ist, ist zwischen dem ersten Schaltungsträger 3 und dem zweiten Schaltungsträger 4 eine Federvorrichtung mit einem ersten Federelement 6 und einem zweiten Federelement 7 vorgesehen. Die beiden Federelemente 6, 7 stützen sich direkt an den Innenseitenflächen 3a, 4a der Schaltungsträger 3, 4 ab. Die beiden Federelemente 6, 7 können aus einem elektrisch leitenden Material hergestellt sein und auch eine elektrische Verbindungsfunktion übernehmen. Alternativ oder zusätzlich könnte ein Federelement zwischen den elektrischen Bauteilen 5 an den beiden Schaltungsträgern 3, 4 angeordnet sein.

Figur 2 zeigt dabei einen Schnitt durch ein Mold-Werkzeug 20 mit einer ersten Werkzeugshälfte 21 und einer zweiten Werkzeughälfte 22. Wie aus Figur 2 ersichtlich ist, sind im Mold-Werkzeug 20 das erste und zweite Federelement 6, 7 zwischen dem ersten und zweiten Schaltungsträger 3, 4 angeordnet. Hierdurch wird eine Außenseitenfläche 3b des ersten Schaltungsträgers gegen eine erste Wandfläche 21a der ersten Werkzeughälfte gedrückt. Gleichzeitig wird die Außenseitenfläche 4b des zweiten Schaltungsträgers 4 gegen eine zweite Wandfläche 22a der zweiten Werkzeughälfte 22 gedrückt. Die beiden Wandflächen 21a, 22a sind dabei parallel zueinander angeordnet. Hierdurch werden auch die beiden Außenseitenflächen 3b, 4b der Schaltungsträger 3, 4 parallel zueinander angeordnet. Die Schaltungsträger 3, 4 sind dabei schon vollständig bestückt, so dass in einem nächsten Schritt eine Mold-Masse in einem inneren Hohlraum 23 im Mold-Werkzeug 20 eingeführt werden kann. Hierbei halten die Federelemente 6, 7 die beiden Schaltungsträger 3, 4 gegen die Wandflächen 21a, 22a gedrückt, so dass im fertigen Bauteil, wie in Figur 1 gezeigt, die beiden Außenseitenflächen 3b, 4b freiliegend zur Außenseite angeordnet sind. Hierdurch können die beiden Außenseitenflächen 3b, 4b zur Wärmeabgabe der elektronischen Baugruppe 1 verwendet werden. Wie aus Figur 1 ersichtlich ist, kann dadurch die Wärme in zueinander um 180° entgegengesetzte Richtungen A (an der ersten Außenseitenfläche 3b) und B (an der zweiten Außenseitenfläche 4b) abgegeben werden.

Hierdurch kann ein sehr einfaches und kostengünstiges Verfahren zur Herstellung der elektronischen Baugruppe 1 mit zwei zueinander parallelen, außen freiliegenden Wärmeabgabeflächen erhalten werden. Die Federelemente 6, 7 werden dabei vollständig von der Mold-Masse umschlossen. Hierdurch weisen die Federelemente 6, 7 in der fertigen elektronischen Baugruppe keine Federeigenschaft mehr auf, da der erstarrte Mold-Körper 2 die Expansion der Federelemente 6, 7 unterbindet. Gegebenenfalls können die Federelemente 6, 7 noch elektrisch leitende Funktionen übernehmen.

Es wird somit die Parallelität des Mold-Werkzeugs 20 verwendet, um elektronische Baugruppen mit zur Außenseite freien Schaltungsträgerflächen zu erzeugen. Hierdurch können elektronische Baugruppen 1 mit großen Kühlflächen auf sehr einfache und kostengünstige Art hergestellt werden.

In diesem Ausführungsbeispiel sind zwei Federelemente vorgesehen. Es sei jedoch angemerkt, dass auch ein einzelner oder auch mehrere Federelemente, beispielsweise vier Federelemente, welche im Wesentlichen an Eckbereichen der Schaltungsträger 3, 4 angeordnet sind, verwendet werden können. Auch können anstatt der dargestellten Spiralfedern auch andere Federelemente verwendet werden.

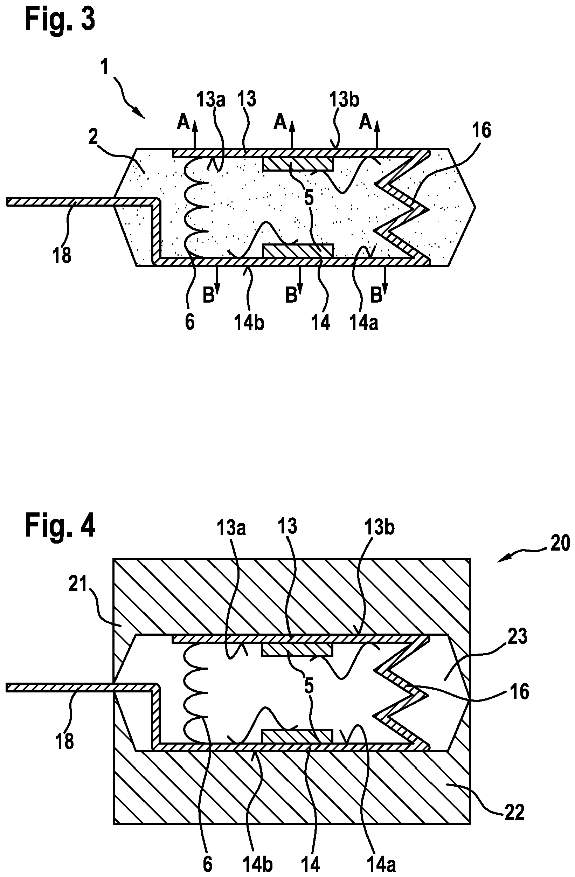

Nachfolgend wird unter Bezugnahme auf die Figuren 3 und 4 eine elektronische Baugruppe 1 gemäß dem Ausführungsbeispiel der Erfindung im Detail beschrieben, wobei gleiche bzw. funktional gleiche Teile mit den gleichen Bezugszeichen wie im ersten Ausführungsbeispiel bezeichnet sind.

Wie aus Figur 3 ersichtlich ist, werden im Unterschied zum Stand der Technik beim Ausführungsbeispiel nicht zwei separate Schaltungsträger verwendet, sondern die Schaltungsträger werden durch ein gemeinsames Bauteil 12, welches auch die Federvorrichtung integriert, dargestellt. Wie aus Figur 3 ersichtlich, ist das gemeinsame Bauteil 12 ein Leadframe, welches ausgehend von einem gemeinsamen elektrischen Verbindungsanschluss 18 oder mehreren elektrischen Verbindungsanschlüssen 18 einen ersten Schaltungsträger 13, einen zweiten Schaltungsträger 14 und eine integrierte Federvorrichtung 16 aufweist. Die integrierte Federvorrichtung 16 wird dabei durch mehrmaliges Umbiegen des Leadframes erhalten und verbindet den ersten Schaltungsträger 13 mit dem zweiten Schaltungsträger 14. Weiter ist zusätzlich noch ein separates Federelement 6 vorgesehen. Insgesamt wird wieder eine elektronische Baugruppe 1 bereitgestellt, bei der die Außenseitenflächen 13b und 14b der Schaltungsträger 13, 14 zur Außenseite freiliegen und als Wärmeabgabeflächen, wie durch die Pfeile A und B angedeutet, verwendet werden können. Die Innenseitenflächen des ersten und zweiten Schaltungsträgers 13, 14 sind mit dem Bezugszeichen 13a und 14a bezeichnet. Der gemeinsame elektrische Verbindungsanschluss 18 ist aus dem Mold-Werkzeug 20 herausgeführt, so dass dann in den Hohlraum 23 wie im ersten Ausführungsbeispiel eine Mold-Masse eingeführt werden kann, um den Mold-Körper 2 zu erzeugen. Hierbei umschließt der Mold-Körper 2 sowohl die integrierte Federvorrichtung 16 als auch das separate Federelement 6.

Ansonsten entspricht dieses Ausführungsbeispiel dem vorhergehenden Ausführungsbeispiel, so dass auf die dort gegebene Beschreibung verwiesen werden kann.

## Patentansprüche

1. Elektronische Baugruppe, umfassend:
- einen ersten Schaltungsträger (13) mit einer ersten Innenseitenfläche (13a), an welcher elektronische Bauteile (5) angeordnet sind, und einer ersten Außenseitenfläche (13b),
- einen zweiten Schaltungsträger (14) mit einer zweiten Innenseitenfläche (14a), an welcher elektronische Bauteile (5) angeordnet sind, und einer zweiten Außenseitenfläche (14b), und
- wobei die erste und zweite Außenseitenfläche (13b, 14b) parallel zueinander sind,
- der erste und zweite Schaltungsträger (13, 14) und eine integrierte Federvorrichtung (16) ein integrales Bauteil (12) sind, wobei das integrale Bauteil (12) ein Leadframe ist, wobei der Leadframe derart umgebogen ist, dass die beiden Schaltungsträger (13, 14) sowie eine integrierte Federvorrichtung (16) als federnder Bereich gebildet sind,
**dadurch gekennzeichnet, dass**
- die elektronische Baugruppe eine zusätzliche, separate Federvorrichtung (6) umfasst, welche die beiden Innenseitenflächen der Schaltungsträger verbindet, und
- die elektronische Baugruppe einen Mold-Körper (2) umfasst, wobei der Mold-Körper (2) dadurch erzeugt wird, dass in einen Hohlraum (23) eines Mold-Werkzeugs (20) eine Mold-Masse eingefügt wird, wobei die Schaltungsträger (13, 14) vollständig bestückt sind, wobei das Federelement (6) die beiden Schaltungsträger (13, 14) gegen jeweils eine Wandfläche (21a, 22a) des Mold-Werkzeuges drückt, so dass die erste und zweite Außenseitenfläche (13b, 14b) zur Außenseite der elektronischen Baugruppe freiliegen, um Wärme direkt zur Außenseite abzugeben, und der Mold-Körper (2) sowohl die integrierte Federvorrichtung (16) als auch das separate Federelement (6) umschließt.

2. Elektronische Baugruppe nach Anspruch 1, **dadurch gekennzeichnet, dass** der erste und zweite Schaltungsträger (13, 14) einen gemeinsamen elektrischen Verbindungsanschluss (18) aufweisen.

3. Elektronische Baugruppe nach einem der vorhergehenden Ansprüche, **dadurch gekennzeichnet, dass** die separate Federvorrichtung (6) aus einem elektrisch leitenden Material hergestellt ist und eine elektrisch leitende Funktion aufweist.

## Claims

1. Electronic assembly, comprising:
- a first circuit carrier (13) having a first inside face (13a), on which electronic components (5) are arranged, and a first outside face (13b),
- a second circuit carrier (14) having a second inside face (14a), on which electronic components (5) are arranged, and a second outside face (14b), and
- wherein the first and second outside faces (13b, 14b) are parallel to one another,
- the first and second circuit carriers (13, 14) and an integragted spring apparatus (16) are an integral component (12), wherein the integral component (12) is a leadframe, wherein the leadframe is bent such that the two circuit carriers (13, 14) and an integrated spring apparatus (16) are formed as a resilient region, **characterized in that**
- the electronic assembly comprises an additional, separate spring apparatus (6) connecting the two inside faces of the circuit carriers, and
- the electronic assembly comprises a moulded body (2), wherein the moulded body (2) is produced by inserting a moulding compound into a cavity (23) in a moulding tool (20), wherein the circuit carriers (13, 14) are fully populated, wherein the spring element (6) pushes the two circuit carriers (13, 14) against one wall face (21a, 22a) of the moulding tool each, so that the first and second outside faces (13b, 14b) are exposed toward the outside of the electronic assembly in order to dissipate heat directly to the outside, and the moulded body (2) encloses both the integrated spring apparatus (16) and the separate spring element (6).

2. Electronic assembly according to Claim 1, **characterized in that** the first and second circuit carriers (13, 14) have a common electrical connection (18).

3. Electronic assembly according to one of the preceding claims, **characterized in that** the separate spring apparatus (6) is manufactured from an electrically conductive material and has an electrically conductive function.

## Revendications

1. Bloc électronique comprenant :
- un premier support de circuit (13) présentant une première surface latérale intérieure (13a), sur laquelle sont disposés des composants électroniques (5), et une première surface latérale extérieure (13b),
- un deuxième support de circuit (14) présentant une deuxième surface latérale intérieure (14a), sur laquelle sont disposés des composants électroniques (5), et une deuxième surface latérale extérieure (14b), et
les première et deuxième surfaces latérales extérieures (13b, 14b) étant parallèles l'une à l'autre,
- les premier et second supports de circuit (13, 14) et un dispositif à ressort intégré (16) constituant un composant intégré (12), le composant intégré (12) étant une grille de connexion, la grille de connexion étant pliée de telle sorte que les deux supports de circuit (13, 14) et un dispositif à ressort intégré (16) soient formés comme une région élastique,
**caractérisé en ce que**
- le bloc électronique comprend un dispositif à ressort séparé supplémentaire (6) qui relie les deux surfaces latérales intérieures du support de circuit, et
- le bloc électronique comprend un corps moulé (2), le corps moulé (2) étant réalisation par insertion d'une matière de moulage dans une cavité (23) d'un outil de moulage (20), les supports de circuit (13, 14) étant complètement équipés, l'élément à ressort (6) pressant les deux supports de circuit (13, 14) contre une surface de paroi respective (21a, 22a) de l'outil de moulage de sorte que les première et deuxième surfaces latérales extérieures (13b, 14b) soient dégagées en direction de l'extérieur du bloc électronique afin de dégager de la chaleur directement vers l'extérieur, et le corps moulé (2) entourant le dispositif à ressort intégré (16) ainsi que l'élément à ressort séparé (6).

2. Bloc électronique selon la revendication 1, **caractérisé en ce que** les premier et deuxième supports de circuit (13, 14) comportent une borne de connexion électrique commune (18).

3. Bloc électronique selon l'une des revendications précédentes, **caractérisé en ce que** le deuxième dispositif à ressort séparé (6) est fabriqué à partir d'un matériau électriquement conducteur et a une fonction électriquement conductrice.
